# EUROPEAN PATENT APPLICATION

(11) **EP 4 765 520 A1**
(43) Date of publication of application: **24.06.2026**
(21) Application number: 24888364.7
(22) Date of filing: 30.08.2024
(51) Int. Cl.: H01R 13/719, H01F 17/06, H01R 31/06, H03H 7/01

(54) **NOISE FILTER**

(30) Priority: 10.11.2023 JP 2023192329
(71) Applicant: Kitagawa Industries Co., Ltd., Inazawa-shi, Aichi 492-8446 (JP)
(72) Inventor: YADA, Tetsuya, Kasugai-shi, Aichi 480-0303 (JP)
(74) Representative: Abel & Imray LLP
(86) International application number: PCT/JP2024/031359
(87) International publication number: WO 2025/100062

(57) **Abstract**

A noise filter that can be added afterwards to a place where a connector is connected is provided.

A noise filter includes a first connection portion, a second connection portion, a conductive portion, and a magnetic core. The first connection portion is configured to be mechanically and electrically connectable to a first connector among the first connector and a second connector configured to be mechanically and electrically connectable to each other. The second connection portion is configured to be mechanically and electrically connectable to the second connector. The conductive portion electrically connects the first connection portion and the second connection portion. The magnetic core is an annular body formed of a magnetic material, and the conductive portion is disposed at a position through which an inner peripheral side of the annular body is penetrated.

## Description

### Technical Field

The present disclosure relates to a noise filter.

### Background Art

A connector having a noise filter therein is known (for example, see Patent Document 1).

### Citation List

### Patent Literature

Patent Document 1: Japanese Patent No. 5950208

### Summary of Invention

### Technical Problem

It is difficult to add a noise filter afterwards to the inside of a connector that does not include a noise filter. Therefore, when the noise filter is required afterwards, the connector itself has to be replaced with a connector of a noise filter built-in type, and there is a problem that such a countermeasure requires cost and labor.

In one aspect of the present disclosure, it is desirable to provide a noise filter that can be added afterwards to a location where a connector is connected.

### Solution to Problem

Configurations of the present disclosure will be described below.
(1) An aspect of the present disclosure is a noise filter including a first connection portion, a second connection portion, a conductive portion, and a magnetic core. The first connection portion is configured to be mechanically and electrically connectable to a first connector among the first connector and a second connector configured to be mechanically and electrically connectable to each other. The second connection portion is configured to be mechanically and electrically connectable to the second connector. The conductive portion configured to electrically connect the first connection portion and the second connection portion. The magnetic core is an annular body formed of a magnetic material and/or containing a magnetic material, and the conductive portion is disposed at a position extending through an inner peripheral side of the annular body.

According to the noise filter configured as described above, when the first connection portion and the first connector are connected to each other and the second connection portion and the second connector are connected to each other, the first connector and the second connector can be electrically connected to each other via the conductive portion. Since the conductive portion is disposed at a position through which an inner peripheral side of the magnetic core is penetrated, when a noise current flows through the conductive portion, the noise current can be attenuated by the magnetic core.

With such a noise filter, even when the first connector and the second connector do not include a noise filter, the noise filter can be added between the first connector and the second connector afterwards.

The noise filter of the present disclosure may further include the following configurations.

(2) In one aspect of the present disclosure, the first connection portion may include a plug contact configured to correspond to the second connector. The second connection portion may include a receptacle contact configured to correspond to the first connector.

(3) In one aspect of the present disclosure, a housing portion configured to accommodate the conductive portion and the magnetic core may be provided. The conductive portion and the magnetic core may be molded with a resin material forming the housing portion.

(4) In one aspect of the present disclosure, the first connection portion may be directed in a first direction and may be configured to be connectable to the first connector directed in a second direction opposite to the first direction. The second connection portion may be directed in the second direction and may be configured to be connectable to the second connector directed in the first direction.

### Brief Description of Drawings

FIG. 1A is a perspective view of a noise filter viewed from an upper right front. FIG. 1B is a perspective view of the noise filter as viewed from the lower left. FIG. 1C is a perspective view illustrating the internal structure of the noise filter.
FIG. 2A is a plan view of the noise filter. FIG. 2B is a left-side view of the noise filter. FIG. 2C is a front view of the noise filter. FIG. 2D is a right-side view of the noise filter. FIG. 2E is a rear view of the noise filter. FIG. 2F is a bottom view of the noise filter.
FIG. 3A is a cross-sectional view of a cut location indicated by line IIIA-IIIA in FIG. 2C. FIG. 3B is a cross-sectional view of a cut location indicated by line IIIB-IIIB in FIG. 2D.
FIG. 4 is a perspective view illustrating an example of use of the noise filter.

### Reference Signs List

1. noise filter, 11. first connection portion, 12. second connection portion, 15. conductive portion, 17. magnetic core, 21. inner fitting portion, 22. pin contact, 23. outer fitting portion, 24. receptacle contact, 25. housing portion, 27. rib, 28. slit, 31. first connector, 32. second connector.

### Description of Embodiments

Next, the noise filter described above will be explained using an exemplary embodiment.

### Configuration of Noise Filter

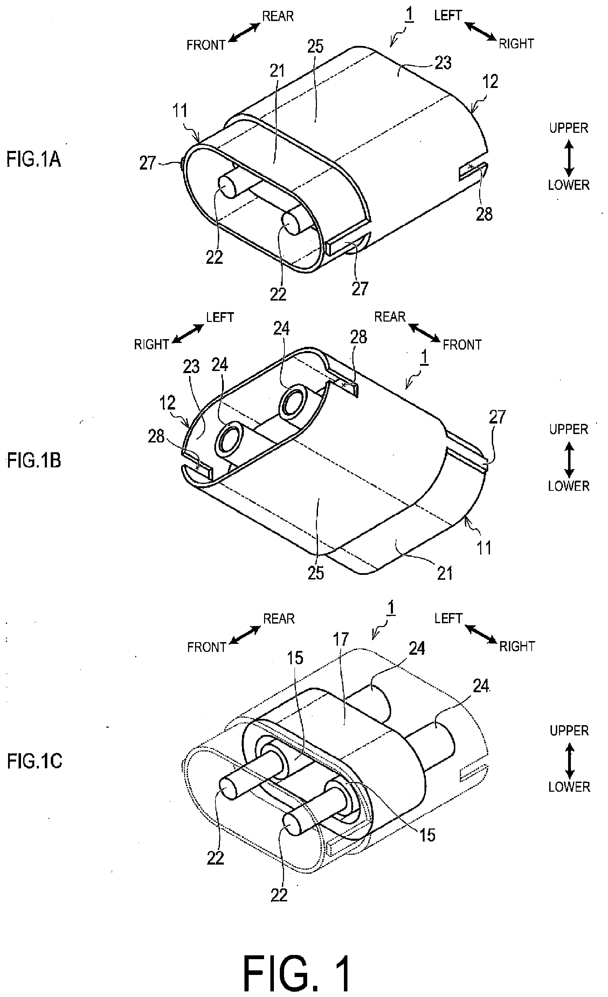

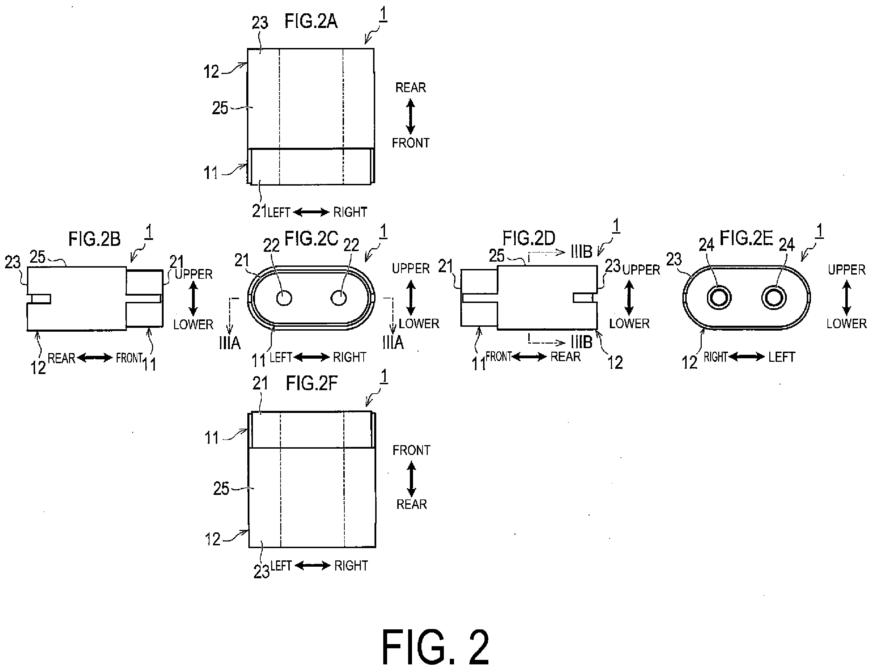

As illustrated in FIGS. 1A, 1B, and 1C, the noise filter 1 includes a first connection portion 11, a second connection portion 12, a conductive portion 15, and a magnetic core 17. In the following description, the description will be made using respective directions of the front, rear, left, right, upper, and lower illustrated in the drawings. Each of these directions is a relative direction in which, in six views of the noise filter 1 (see FIGS. 2A, 2B, 2C, 2D, 2E, and 2F), a direction in which a part illustrated in a front view faces is defined as front, a direction in which a part illustrated in a back view faces is defined as back, a direction in which a part illustrated in a left side view faces is defined as left, a direction in which a part illustrated in a right side view faces is defined as right, a direction in which a part illustrated in a plan view faces is defined as up, and a direction in which a part illustrated in a bottom view faces is defined as down. However, each of these directions is merely a direction defined for simply describing a relative position of each part constituting the noise filter 1. Therefore, the direction in which the noise filter 1 is installed when the noise filter 1 is used is arbitrary.

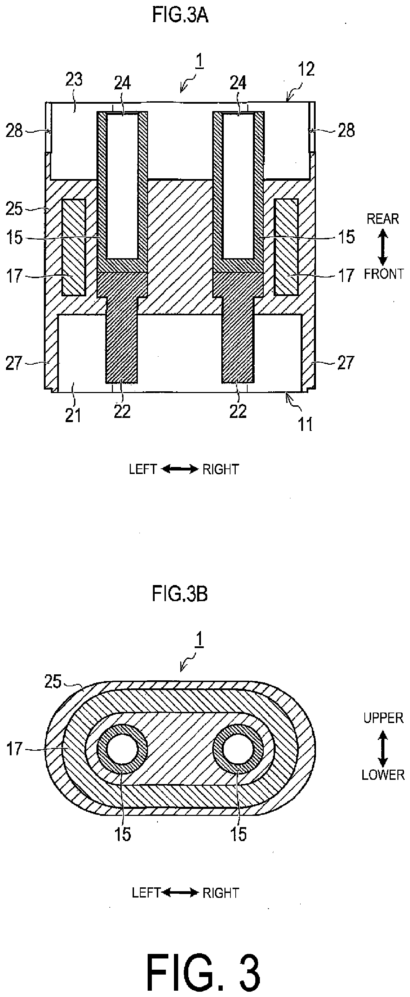

The first connection portion 11 includes an inner fitting portion 21 and two pin contacts 22. The second connection portion 12 includes an outer fitting portion 23 and two receptacle contacts 24. The inner fitting portion 21 and the outer fitting portion 23 are integrally molded with a housing portion 25 formed of resin. As illustrated in FIGS. 3A and 3B, a part of the pin contact 22, a part of the receptacle contact 24, and the magnetic core 17 are accommodated in the housing portion 25 and molded with a resin material forming the housing portion 25. A part of the pin contact 22 and a part of the receptacle contact 24 protrude to the outside of the housing portion 25.

The protruding portion of the pin contact 22 is formed in a columnar shape and is disposed on the inner peripheral side of the inner fitting portion 21. The protruding portion of the receptacle contact 24 is formed in a cylindrical shape and is disposed on the inner peripheral side of the outer fitting portion 23. The pin contacts 22 and the receptacle contacts 24 are connected one-to-one inside the housing portion 25 to constitute the conductive portion 15. The conductive portion 15 is disposed at a position through which the inner peripheral side of the magnetic core 17 is penetrated.

The inner fitting portion 21 is formed in a tubular shape that looks substantially oval in a front view. The outer fitting portion 23 is formed in a tubular shape that looks substantially oval in a back view. Ribs 27 are formed on the left and right side surfaces of the inner fitting portion 21. Slits 28 are formed in the left and right side surfaces of the outer fitting portion 23.

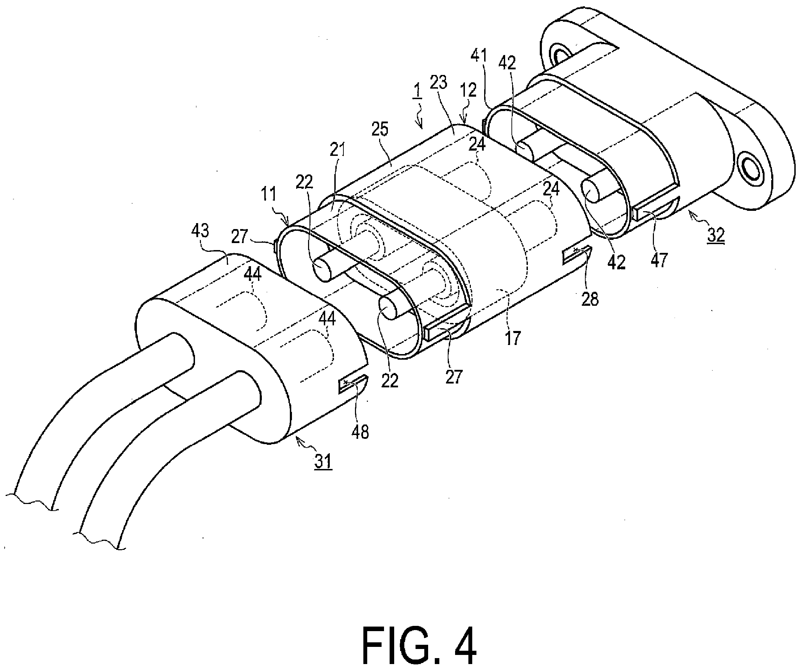

The noise filter 1 configured as described above can be connected to a first connector 31 and a second connector 32 as illustrated in FIG. 4. The first connector 31 and the second connector 32 are connectors configured to be connectable to each other. With respect to the first connector 31 and the second connector 32, the first connection portion 11 has a structure compatible with the second connector 32, and the second connection portion 12 has a structure compatible with the first connector 31.

More specifically, the inner fitting portion 21, the pin contact 22, and the rib 27 of the first connection portion 11 are configured to have the same shape and size as the inner fitting portion 41, the pin contact 42, and the rib 47 of the second connector 32. The outer fitting portion 23, the receptacle contact 24, and the slit 28 of the second connection portion 12 are configured to have the same shape and size as the outer fitting portion 43, the receptacle contact 44, and the slit 48 of the first connector 31.

Therefore, the first connector 31 can be mechanically and electrically connected to the first connection portion 11 having a structure compatible with the second connector 32. Specifically, the inner fitting portion 21 of the first connection portion 11 is fitted to the inner peripheral side of the outer fitting portion 43 of the first connector 31, and at this time, the ribs 27 of the first connection portion 11 enter the slits 48 of the first connector 31, whereby the first connection portion 11 and the first connector 31 are mechanically connected to each other. The pin contacts 22 of the first connection portion 11 are inserted into the receptacle contacts 44 of the first connector 31, whereby the first connection portion 11 and the first connector 31 are electrically connected to each other.

The second connector 32 can be mechanically and electrically connected to the second connection portion 12 having a structure compatible with the first connector 31. Specifically, the outer fitting portion 23 of the second connection portion 12 is fitted to the outer peripheral side of the inner fitting portion 41 of the second connector 32, and at this time, the ribs 47 of the second connector 32 enter the slits 28 of the second connection portion 12, whereby the second connection portion 12 and the second connector 32 are mechanically connected to each other. The pin contacts 42 of the second connector 32 are inserted into the receptacle contacts 24 of the second connection portion 12, whereby the second connection portion 12 and the second connector 32 are electrically connected to each other.

When the first connector 31 and the second connector 32 are connected to the noise filter 1, the first connector 31 and the second connector 32 are electrically connected to each other via the conductive portion 15 included in the noise filter 1. When a noise current flows through the conductive portion 15, the magnetic core 17 attenuates the noise current. Therefore, compared to a case where the first connector 31 and the second connector 32 are directly connected, noise transmitted from one of the first connector 31 and the second connector 32 to the other can be attenuated.

With such a noise filter 1, even when the first connector 31 and the second connector 32 do not include a noise filter, the noise filter 1 can be added between the first connector 31 and the second connector 32 afterwards.

### Other Embodiments

While the noise filter has been described above with reference to the exemplary embodiments, the embodiments described above are merely examples of an aspect of the present disclosure. That is, the present disclosure is not limited to the exemplary embodiments described above, and can be carried out in various forms without departing from the technical concept of the present disclosure.

For example, in the above embodiment, for the sake of simplicity of illustration, the specific shapes of the pin contact 22 and the receptacle contact 24 are described as a columnar shape and a cylindrical shape, respectively, but a structure for further facilitating insertion and removal may be provided. For example, in the case of the pin contact 22, a structure in which the outer diameter dimension is expanded and contracted, such as a so-called banana plug, may be adopted. In the case of the receptacle contact 24, several split grooves may be formed from the cylindrical end portion so that the inner diameter of the cylindrical end portion is increased or decreased.

The pin contact 22 and the receptacle contact 24 may be an integral component or may be separate components as long as they are electrically connected to each other. When the pin contact 22 and the receptacle contact 24 are formed as an integral component, a part of the integral component constitutes the pin contact 22, and another part of the integral component, which is different from the part of the integral component constituting the pin contact 22, constitutes the receptacle contact 24. A part of the conductive portion 15 between the pin contact 22 and the receptacle contact 24 constitutes the conductive portion 15. When the pin contact 22 and the receptacle contact 24 are separate components, the pin contact 22 and the receptacle contact 24 may be directly connected to each other to form the conductive portion 15. Alternatively, the conductive portion 15 may be formed by interposing another conductive component between the pin contact 22 and the receptacle contact 24.

In the above embodiment, the first connector 31 and the second connector 32 have different contacts. However, the first connector 31 and the second connector 32 may have the same contacts. For example, one of the two contacts of the first connector 31 may have the same shape as the pin contact 22, and the other may have the same shape as the receptacle contact 24. In this case, one of the two contacts of the second connector 32 has the same shape as the pin contact 22, and the other has the same shape as the receptacle contact 24, and the first connector 31 and the second connector 32 have the same structure. In this case, the first connection portion 11 and the second connection portion 12 also have the same structure as the first connector 31 and the second connector 32.

In the above embodiment, an example in which the first connector 31 and the second connector 32 form two conductive paths has been described, but the number of conductive paths formed by the first connector 31 and the second connector 32 can be changed as desired. In this case, the number of conductive paths formed by the noise filter 1 is set to a number corresponding to the number of conductive paths formed by the first connector 31 and the second connector 32.

In the above embodiment, the noise filter 1 is configured to form two conductive paths, and all of the two conductive paths pass through the inner peripheral side of the magnetic core 17, but some of the conductive paths may be configured to pass through the outer peripheral side of the magnetic core 17. Alternatively, the configuration may be such that some of the conductive paths pass through the inner peripheral side of the magnetic core 17, then make a U-turn toward the outer peripheral side of the magnetic core 17, and then make a U-turn again to pass through the inner peripheral side of the magnetic core 17 again.

Note that a plurality of functions implemented by one component illustrated in the above embodiment may be implemented by a plurality of components. One function implemented by one component illustrated in the above embodiment may be implemented by a plurality of components. A plurality of functions implemented by a plurality of components illustrated in the above embodiment may be implemented by one component. One function implemented by a plurality of components illustrated in the above embodiment may be implemented by one component. Additionally, a portion of the configurations exemplified in the embodiments described above may be omitted.

### Technical Concept Disclosed in Specification

### [Item 1]

A noise filter comprising:
a first connection portion configured to be mechanically and electrically connectable to a first connector among the first connector and a second connector configured to be mechanically and electrically connectable to each other;
a second connection portion configured to be mechanically and electrically connectable to the second connector;
a conductive portion configured to electrically connect the first connection portion and the second connection portion;
a magnetic core that is an annular body formed of a magnetic material and/or containing a magnetic material, and in which the conductive portion is disposed at a position extending through an inner peripheral side of the annular body.

### [Item 2]

The noise filter according to item 1, wherein
the first connection portion includes a plug contact configured to correspond to the second connector, and
the second connection portion includes a receptacle contact configured to correspond to the first connector.

### [Item 3]

The noise filter according to item 1 or 2, comprising a housing portion configured to accommodate the conductive portion and the magnetic core, wherein
the conductive portion and the magnetic core are molded with a resin material configured to form the housing portion.

### [Item 4]

The noise filter according to any one of items 1 to 3, wherein
the first connection portion is directed in a first direction and is configured to be connectable to the first connector directed in a second direction opposite to the first direction, and
the second connection portion is directed in the second direction and is configured to be connectable to the second connector directed in the first direction.

## Claims

1. A noise filter comprising:
a first connection portion configured to be mechanically and electrically connectable to a first connector, among the first connector and a second connector configured to be mechanically and electrically connectable to each other;
a second connection portion configured to be mechanically and electrically connectable to the second connector;
a conductive portion configured to electrically connect the first connection portion and the second connection portion;
a magnetic core that is an annular body formed of a magnetic material and/or containing a magnetic material, and in which the conductive portion is disposed at a position extending through an inner peripheral side of the annular body.

2. The noise filter according to claim 1, wherein
the first connection portion includes a plug contact configured to correspond to the second connector, and
the second connection portion includes a receptacle contact configured to correspond to the first connector.

3. The noise filter according to claim 1 or 2, comprising:
a housing portion configured to accommodate the conductive portion and the magnetic core, wherein
the conductive portion and the magnetic core are molded with a resin material configured to form the housing portion.

4. The noise filter according to claim 1 or 2, wherein
the first connection portion is directed in a first direction and is configured to be connectable to the first connector directed in a second direction opposite to the first direction, and
the second connection portion is directed in the second direction and is configured to be connectable to the second connector directed in the first direction.
